# EUROPEAN PATENT APPLICATION

(11) **EP 4 597 128 A1**
(43) Date of publication of application: **06.08.2025**
(21) Application number: 23870274.0
(22) Date of filing: 11.09.2023
(51) Int. Cl.: G01R 31/28, G01R 31/317, G01R 31/3181, G01R 31/3183, G01R 31/3185

(54) **FAULT LOCATION CIRCUIT AND METHOD, AND CHIP AND COMPUTER-READABLE STORAGE MEDIUM**

(30) Priority: 28.09.2022 CN 202211196928
(71) Applicant: Sanechips Technology Co., Ltd., Shenzhen, Guangdong 518055 (CN)
(72) Inventor: OUYANG, Keqing, Shenzhen, Guangdong 518055 (CN); PENG, Minqiang, Shenzhen, Guangdong 518055 (CN); ZHOU, Guohua, Shenzhen, Guangdong 518055 (CN); WANG, Shuai, Shenzhen, Guangdong 518055 (CN); WANG, Kai, Shenzhen, Guangdong 518055 (CN)
(74) Representative: Cristinelli, Luca
(86) International application number: PCT/CN2023/117939
(87) International publication number: WO 2024/067035

(57) **Abstract**

Disclosed in the present application are a fault location circuit and method, and chip and computer-readable storage medium. The fault location circuit includes a scan array and a dedicated debug chain. The scan array includes a plurality of scan-cells and XOR cells, where the scan-cells are sequentially connected end to end in a first direction to form a plurality of columns of scan chains, the scan-cells adjacent in a second direction are same-level scan-cells, the XOR cells are arranged between the same-level scan-cells, the XOR cells adjacent in the second direction are same-level XOR cells, and the same-level XOR cells in the second direction are sequentially connected to form an XOR chain. The dedicated debug chain consists of the plurality of scan-cells sequentially connected end to end in the first direction, and the scan-cells in the dedicated debug chain are connected to output ends of the XOR chains respectively. An output result of the scan array is used to determine a column coordinate of a faulty scan-cell, and an output result of the dedicated debug chain is used to determine a row coordinate of the faulty scan-cell.

## Description

### Cross-Reference to Related Application

The invention claims the priority to Chinese Patent Application No. 202211196928.2, filed with the China National Intellectual Property Administration on September 28, 2022 and entitled "Fault location circuit and method, and chip and computer-readable storage medium", which is incorporated in its entirety herein by reference.

### Technical Field

Examples of the invention relate to, but are not limited to, the technical field of integrated circuit testing, and particularly relate to a fault location circuit and method, a chip and a computer-readable storage medium.

### Background

With ceaseless improvement of an advanced chip processing process, the number of transistors integrated on a chip is also exponentially increased. Improvement of yield has become a key element in a chip manufacturing process. Importance of integrated circuit fault diagnosis has become progressively more prominent.

In a real chip, the scan-cell and its clock path occupy about 30% of an area of the entire chip. As an internal test circuit, the scan chain, similar to other logic, inevitably has some faults. According to statistics, 10%-30% of scan-cell faults may cause a failure of the entire scan chain, and 50% of chip faults are caused by the scan chain. Accordingly, fault diagnosis of the scan chain and high-precision location of the scan-cell are of great significance.

Currently, to implement fault diagnosis of scan chains and high-precision location of scan-cells, it is necessary to change to increase input ports of the scan-cells, or introduce complex fault diagnosis algorithms. However, the former leads to the problem of circuit layout and routing congestion, and the latter causes high computational complexity and sample imbalance.

### Summary

A main objective of the invention is to provide a fault location circuit and method, a chip and a computer-readable storage medium for efficiently and accurately locating a faulty scan-cell, so as to avoid technical defects such as circuit layout and routing congestion, high computational complexity and sample imbalance.

In order to achieve the above objective, the invention provides a fault location circuit. The fault location circuit includes a scan array and a dedicated debug chain. The scan array includes a plurality of scan-cells and XOR cells, the scan-cells are sequentially connected end to end in a first direction to form a plurality of columns of scan chains, the scan-cells adjacent in a second direction are same-level scan-cells, the XOR cells are arranged between the same-level scan-cells, the XOR cells adjacent in the second direction are same-level XOR cells, and the same-level XOR cells in the second direction are sequentially connected to form an XOR chain, where the first direction is different from the second direction; the dedicated debug chain consists of the plurality of scan-cells sequentially connected end to end in the first direction, and the scan-cells in the dedicated debug chain are connected to output ends of the XOR chains respectively; and an output result of the scan array is used to determine a column coordinate of a faulty scan-cell, and an output result of the dedicated debug chain is used to determine a row coordinate of the faulty scan-cell.

Moreover, in order to achieve the above objective, the invention further provides a fault location method. The fault location method is applied to the above fault location circuit and includes: inputting a test vector to a scan array; obtaining an output result of the scan array, comparing the output result of the scan array with the test vector, and determining a column coordinate of a faulty scan-cell; inputting designated data to the scan array; obtaining an output result of a dedicated debug chain, comparing the output result of the dedicated debug chain with the specified data, and determining a row coordinate of the faulty scan-cell; and determining a position of the faulty scan-cell in the scan array according to the column coordinate and the row coordinate.

Moreover, in order to achieve the above objective, the invention further provides a chip. The chip includes: a memory, a processor, and a computer program stored on the memory and runnable on the processor. The computer program implements the above fault location method when executed by the processor.

Moreover, in order to achieve the above objective, the invention further provides a computer-readable storage medium. The computer-readable storage medium stores a computer program. The computer program implements the above fault location method when executed by a processor.

### Brief Description of the Drawings

In order to describe the technical solutions in examples of the invention or in the prior art more clearly, the accompanying drawings required for describing the examples or the prior art are briefly described below. Apparently, the accompanying drawings in the following description are merely part of the invention. Those of ordinary skill in the art can also derive other accompanying drawings from these accompanying drawings without creative efforts.
Fig. 1 is a schematic structural diagram of a fault location circuit according to an example of the invention;
Fig. 2 is a schematic structural diagram of a scan-cell involved in a fault location circuit according to an example of the invention;
Fig. 3 is a schematic diagram of an application scenario of a fault location circuit according to an example of the invention;
Fig. 4 is a schematic diagram of another application scenario of a fault location circuit according to an example of the invention;
Fig. 5 is a flowchart of a fault location method according to an example of the invention; and
Fig. 6 is a schematic structural diagram of hardware of a chip according to an example of the invention.

### Detailed Description of the Embodiments

In the following description, for purposes of explanation instead of limitation, specific details are set forth, such as particular system structures and technology to provide a thorough understanding of examples of the invention. However, those of ordinary skill in the art should understand that the examples of the invention can be implemented in other examples without these specific details. In other cases, detailed descriptions of well-known systems, devices, circuits, and methods are omitted so as not to obscure the description of the examples of the invention with unnecessary details.

It should be noted that although logic orders are shown in the flowcharts, in some cases, the steps shown or described may be executed in an order different from those in the flowcharts. The terms "first", "second" and so forth, in the specification and claims and the above-mentioned drawings, are used to distinguish between similar objects, instead of necessarily describing a particular order or a sequential order.

It should also be understood that reference to "one example" or "some examples", etc. described in the description of the examples of the invention means that a specific feature, structure, or characteristic described in connection with the example is included in one or more examples of the invention. Thus, the phrases "in one example", "in some examples", "in some other examples", "in yet other examples", etc. in different places of the present description are not necessarily all referring to the same example, but mean "one or more but not all examples", unless specifically emphasized otherwise. The terms "comprise", "encompass", "have", and their variations mean "comprise, but is not limited to", unless specifically emphasized otherwise.

With ceaseless improvement of an advanced chip processing process, the number of transistors integrated on a chip is also exponentially increased. Improvement of yield has become a key element in a chip manufacturing process. Importance of integrated circuit fault diagnosis has become progressively more prominent.

In a test process, since a large number of combinational logic and sequential logic are provided in the chip, register data in the circuit can hardly be measured and controlled directly, then observability and controllability are low, and testability of the entire chip can hardly meet requirements. Traditional physical means such as scanning electron microscope cannot effectively locate a fault in current advanced chips, and Design For Test (DFT) based on a scan chain emerges as the times require.

The scan chain is a structure in which function registers are replaced by scan-cells in a logic circuit and the Scan-cells are connected in series to form a chain. Through the scan chain, test data can be effectively transmitted to the inside of the logic circuit, and an output value of a cell to be tested is transmitted and output, such that a test function is implemented. Under control of a multiplexer (MUX, data selector) selection signal of the scan-cell, the scan chain is generally provided with two working modes of a function mode and a test mode. In the function mode, essence of the scan-cell is to execute a function of a register, mainly storing the data of combinational logic, and working according to an original structure. In the test mode, the test data are shifted and input from the scan chain in sequence, and then are shifted and output from the scan chain for comparison after logic data are captured.

In a real chip, the scan-cell and its clock path occupy about 30% of an area of the entire chip. As an internal test circuit, the scan chain, similar to other logic, inevitably has some faults. According to statistics, 10%-30% of scan-cell faults may cause a failure of the entire scan chain, and 50% of chip faults are caused by the scan chain. Accordingly, fault diagnosis of the scan chain and high-precision location of the scan-cell are of great significance.

Generally, one scan chain may be composed of tens, hundreds or even more scan-cells. In a traditional method, a test vector is shifted into the scan chain from one end and then shifted out from the other end. A faulty scan chain is easily detected by comparison with an input vector. However, due to the large number of the scan-cells in the chain, it is a challenge to locate a faulty scan-cell. Main reasons are as follows: first, a faulty scan-cell result can only be shifted and output sequentially from the scan chain, and a scan-cell result at a specific position in the chain cannot be directly observed. Second, in a diagnosed scan chain with a fault, when the test vector is shifted to a faulty scan-cell, for example, with a stuck-at 1 fault, all subsequent data are contaminated, and no matter what a value of the subsequent vector is, output values after the faulty scan-cell are all 1. Third, during data capture, in a case that input of a scan-cell is output of another faulty scan-cell, that is, the scan-cell captures an error value, but in a subsequent shift process, another faulty scan-cell in the scan chain is passed through, and it is impossible to determine, in a final shift output vector, whether the data are caused by the captured error data or by contamination of the subsequent faulty scan-cell.

In order to accurately locate the faulty scan-cell in the scan chain, there are currently two possible solutions. The first solution is to use a two-dimensional scan chain. Specifically, the solution is to connect output of any independent scan-cell to next scan-cells in a horizontal direction and a vertical direction separately, and finally to form a two-dimensional scan chain. After the scan chain is formed, the test vector is shifted from horizontal, vertical or diagonal paths to the inside of the circuit sequentially. According to whether output of different scan paths matches an input value, a fault point can be accurately located. However, when the number of faulty scan-cells increases or fault points are concentrated, an input port of the scan-cells needs to be added to the solution for effective location. However, this may lead to layout and routing congestion. The second solution is to accurately locate the faulty scan-cell in the scan chain by optimizing a scan chain fault diagnosis algorithm or introducing machine learning, such as an artificial neural network (ANN), and a deep neural network (DNN), without changing scan-cell design and a scan chain structure. However, when the number of the scan-cells is large, calculation complexity is high, and sample imbalance exists.

In view of this, the examples of the invention provide a fault location circuit and method, an apparatus and a computer-readable storage medium. The fault location circuit includes: a scan array, where the scan array includes a plurality of scan-cells and XOR cells, the scan-cells are sequentially connected end to end in a first direction to form a plurality of columns of scan chains, the scan-cells adjacent in a second direction are same-level scan-cells, the XOR cells are arranged between the same-level scan-cells, the XOR cells adjacent in the second direction are same-level XOR cells, and the same-level XOR cells in the second direction are sequentially connected to form an XOR chain, where the first direction is different from the second direction; and a dedicated debug chain, where the dedicated debug chain consists of the plurality of scan-cells sequentially connected end to end in the first direction, and the scan-cells in the dedicated debug chain are connected to output ends of the XOR chains respectively. An output result of the scan array is used to determine a column coordinate of a faulty scan-cell, and an output result of the dedicated debug chain is used to determine a row coordinate of the faulty scan-cell.

According to the fault location circuit provided in the example of the invention and provided with a dedicated debug chain, a scan chain with a fault can be identified by using a conventional scan chain diagnosis method, that is, the column coordinate of the faulty scan-cell can be obtained. Then a specific test vector is shifted and input, passes through output values of the same-level scan-cells adjacent in the horizontal direction, then performs XOR operation sequentially, and then shifts the output values to the corresponding scan-cells on the dedicated debug chain, so as to obtain the row coordinate of the faulty scan-cell. The pollution caused by the faulty scan-cell to the subsequent data during data shifting can be effectively solved. Finally, high-precision location of the faulty scan-cell is implemented. For a scan-cell having a plurality of faults at the same time, accurate location can be implemented by setting the scan-cell.

Compared with a two-dimensional serial chain in the prior art, the dedicated debug chain in the fault location circuit of the example of the invention can multiplex an ordinary vertical scan chain, and except for XOR processing on the output result of the scan-cell, no other hardware overhead is introduced, such that no congestion problem occurs in subsequent layout and routing. Compared with a diagnosis and positioning method by optimizing a scan chain fault diagnosis algorithm or introducing machine learning in the prior art, the fault location circuit including the dedicated debug chain and provided in the example of the invention does not need complex logic calculation, location of the faulty scan-cells is efficient and accurate, and the problem of unbalanced number of faulty scan-cells does not exist. The fault location circuit provided in the example of the invention can implement high-precision diagnosis on any number of faulty scan-cells at any position, and has strong universality.

The fault location circuit and method, the apparatus and the computer-readable storage medium provided in the examples of the invention are specifically described through the following examples. First, the fault location circuit in the examples of the invention is described.

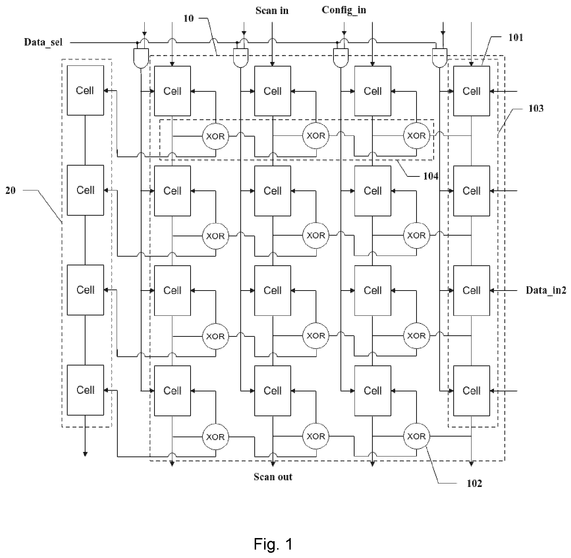

The examples of the invention provide a fault location circuit. With reference to Fig. 1, Fig. 1 is a schematic structural diagram of a fault location circuit according to an example of the invention. As shown in Fig. 1., the fault location circuit in the example includes a scan array 10 and a dedicated debug chain 20.

The scan array 10 includes a plurality of scan-cells 101 and XOR cells 102. The scan-cells 101 are sequentially connected end to end in a first direction to form a plurality of columns of scan chains 103. The scan-cells 101 adjacent in a second direction are same-level scan-cells. The XOR cells 102 are arranged between the same-level scan-cells. The XOR cells 102 adjacent in the second direction are same-level XOR cells. The same-level XOR cells in the second direction are sequentially connected to form an XOR chain 104. The first direction is different from the second direction.

The dedicated debug chain 20 consists of the plurality of scan-cells 101 sequentially connected end to end in the first direction. The scan-cells 101 in the dedicated debug chain 20 are connected to output ends of the XOR chains 104 respectively.

An output result of the scan array 10 is used to determine a column coordinate of a faulty scan-cell 101, and an output result of the dedicated debug chain 20 is used to determine a row coordinate of the faulty scan-cell 101.

It should be noted that in the example, the scan-cells 101 constituting the dedicated debug chain 20 are all known unfaulty scan-cells, and the number of the scan-cells is consistent with the number of scan-cells 101 constituting one scan chain 103. Accordingly, the scan-cells 101 (that is, Cell in Fig. 1) in the dedicated debug chain 20 adjacent to the scan-cells 101 in the scan array 10 in the second direction can also be regarded as the same-level scan-cells. A difference lies in that no XOR cell 102 needs to be arranged the same-level scan-cells in the dedicated debug chain 20 and the scan array 10. For convenience of description, in the structural diagram of the fault location circuit as shown in Fig. 1, the first direction is regarded as a vertical direction, and the second direction is regarded as a horizontal direction (in this case, the first direction and the second direction are orthogonal to each other, and the example is only an instance. As long as the first direction is not parallel to the second direction, they both belong to the protection range summarized by the different directions mentioned in the example). The scan-cells 101 adjacent in the vertical direction are sequentially connected end to end to form a plurality of scan chains 103. Input signals of the scan chain 103 are Scan in, and output signals are Scan out. One XOR cell 102 (that is, XOR in Fig. 1) is arranged between every two scan-cells 101 adjacent in the horizontal direction. The XOR cells 102 have no connection relationship in the vertical direction, but the XOR cells 102 adjacent in the horizontal direction are sequentially connected to form a plurality of XOR chains 104. Output ends of the XOR chains 104 are connected to the same-level scan-cells in the dedicated debug chain 20 respectively. Under the condition of normal operation of the scan-cells 101, the input vector and the output vector passing through the scan-cells have a same value. Under the condition of faults, a vector value passing through the scan-cell is forcibly converted to 0 or 1. The XOR cells 102 are configured to perform XOR logic operation, follow an operation rule of 0 for same and 1 for different, that is, in a case that two input values are the same, the output value is 0, and in a case that two input values are different, the output value is 1.

In the example, in order to facilitate detection of most common scan-cell fault types in the scan chains, the test vector shifted and input to each vertical scan chain 103 is a sequence of 001100110011, which can detect all four different signal transitions of any scan-cell, that is, 0-0, 0-1, 1-0, and 1-1. Since the test vector is shifted from the input end to the output end of the scan chain 103, each scan-cell in the scan chain is diagnosed. In a case that a vector sequence obtained from a shift output end of the vertical scan chain is also 001100110011, that is, the vector sequence is consistent with the input diagnostic vector, it means that the scan chain is normal.

The fault location circuit provided in the example can identify the scan chain with a fault by using the conventional scan chain diagnosis method, that is, by comparing the input vector and output vector of each scan chain in the scan array, it can be determined that which scan chain has a fault, and then the column coordinate of the faulty scan-cell is obtained. The specific test vector is shifted and input, sequentially performs XOR operation on the output values of the same-level scan-cells adjacent in the horizontal direction based on the XOR chains, then shifts the output values to the corresponding same-level scan-cells on the dedicated debug chain, determines which row of scan-cells have a fault in the horizontal direction according to the output values of the dedicated debug chain, and further obtains the row coordinate of the faulty scan-cell. After the column coordinate and the row coordinate of the faulty scan-cell are obtained, the position of the faulty scan-cell can be accurately determined in the scanning array.

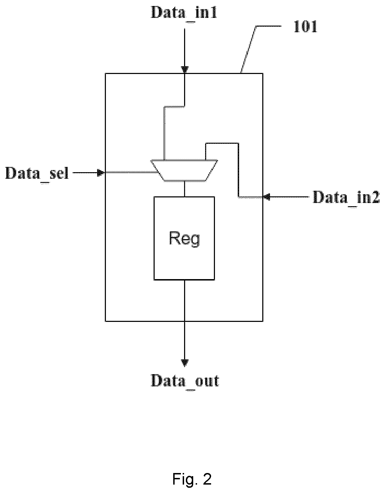

In some feasible examples, with reference to Fig. 2, Fig. 2 is a schematic structural diagram of a scan-cell involved in a fault location circuit according to an example of the invention. As shown in Fig. 2, the scan-cell 101 includes:
a first data input end Data_in1, where the first data input end Data_in1 is configured to receive a test vector;
a second data input end Data_in2, where the second data input end Data_in2 is configured to receive setting data;
a data selection end Data_sel, where the data selection end Data_sel is configured to selectively receive the test vector or the setting data; and
a data output end Data_out, where the data output end Data_out is configured to output a detection result.

In the example, an upper port of the scan-cell 101 in Fig. 2, that is, the first data input end Data_in1, may be configured to receive the test vector. A right port of the scan-cell, that is, the second data input end Data_in2, may be configured to receive the setting data.

The setting data may be 0 or 1. A left port, that is, the data selection end Data_sel, is configured to select whether the scan-cell 101 receives the test vector through the first data input end Data_in1 or the setting data through the second data input end Data_in2. A lower port, that is, the data output end Data_out, may be configured to output the detection result.

With reference to Fig. 1, it can be seen that the scan-cells 101 adjacent in the vertical direction are connected end to end, that is, a data output end Data_out of a previous scan-cell is connected to a first data input end Data_inl of a subsequent scan-cell. After forming the scan chain 103, the first data input end Data_in1 of the scan-cell 101 located at a top of the scan chain 103 is configured to receive test vectors input by a scan line Scan in. The data output end Data_out of the scan-cell 101 located at a bottom of the scan chain 103 is configured to output the detection result of the current scan chain 103 to an output scan line Scan out. The second data input end Data_in2 of each scan-cell 101 on a rightmost side in the scan array 10 may be configured to receive setting data, and the second data input ends Data_in2 of other scan-cells 101 are connected to the XOR cell 102. The data selection end Data_sel of each scan-cell 101 in the scan array 10 is connected to an output end of an AND gate, and two input ends of the AND gate are connected to a Data_sel signal and a Config_in signal respectively. In the example, only when the Data_sel signal is 1 and the Config_in signal is 1, the scan-cell 101 selects to receive the setting data through the second data input end Data_in2. In other cases, it is assumed that the scan-cell 101 receives the test data through the first data input end Data_in1.

It should be noted that, at the same time, each scan-cell 101 in the scan array 10 only receives a test vector from one input end, and the data selection end Data_sel of each scan-cell 101 in the dedicated debug chain 20 is empty. Each scan-cell 101 in the dedicated debug chain 20 may receive test vectors from both input ends simultaneously (the first data input end Data_inl of the top scan-cell in dedicated debug chain 20 is empty). This is because the scan-cells 101 in the dedicated debug chain 20 are unfaulty scan-cell. After receiving the test vectors, the scan-cells only shift and output the accessed test vectors to the next scan-cells along with a clock signal, and do not influence the values and ordering of the test vectors.

In some feasible examples, each XOR cell 102 includes a first logic input end, a second logic input end, a first logic output end, and a second logic output end.

In some feasible examples, the scan chains 103 include a boundary chain and intermediate chains.

The XOR cells 102 include a head XOR cell arranged between the boundary chain and the intermediate chain, an intermediate XOR cell arranged between two intermediate chains, and a tail XOR cell closest to the dedicated debug chain 20.

The head XOR cell, the intermediate XOR cell and the tail XOR cell are sequentially connected to form the XOR chain 104.

It should be noted that the example can also be understood in conjunction with Fig. 1, and a right port of the XOR unit 102 is referred to as the first logic input end, a left port as the second logic input end, an upper port as the first logic output end, and a lower port as the second logic output end. In the example, based on different port connection relationships of the scan-cells 101 in the scan chains 103, the scan chain 103 on the rightmost side of the scan array 10 in Fig. 1 is referred to as the boundary chain, and the remaining scan chains 103 in the scan array 10 are referred to as the intermediate chains. As shown in Fig. 1, a difference between the boundary chain and the intermediate chains mainly lies in that the second data input end Data_in2 of each scan-cell 103 in the boundary chain is connected differently. The second data input end Data_in2 of each scan-cell 103 in the boundary chain may be configured to receive setting data from a data line, and the second data input end Data_in2 of each scan-cell 101 in the intermediate chains is connected to the first logic output end of the XOR cell 102. The head XOR cells are a row of XOR cells adjacent to the boundary chain, are also a rightmost row of XOR cells in Fig. 1. The tail XOR cells are a row of XOR cells closest to the dedicated debug chain 20, and are also a leftmost row of XOR cells in Fig. 1. The intermediate XOR cells are located between the head XOR cells and the tail XOR cells. The second logic output ends of the head XOR cells are connected to the first logic input ends of the intermediate XOR cells. The second logic output ends of the intermediate XOR cells are connected to the first logic input ends of the tail XOR cells, that is, the XOR chains 104 are formed. The output ends of the XOR chains 104, that is, the second logic output ends of the tail XOR cells, are connected to the same-level scan-cells in the dedicated debug chain 20, and perform XOR processing for a plurality of times on the output values of the same-level scan-cells 101 in the scan array 10 adjacent in the horizontal direction and then transmit the output values to the dedicated debug chain 20, such that the position of the faulty scan-cell can be deduced from the output of the dedicated debug chain 20.

In some feasible examples, a first logic input end of the head XOR cell is connected to a data output end of the same-level scan-cell in the boundary chain, a second logic input end of the head XOR cell is connected to a data output end of the same-level scan-cell in the intermediate chain, a first logic output end of the head XOR cell is connected to a second data input end of the same-level scan-cell in the intermediate chain, and a second logic output end of the head XOR cell is connected to a first logic input end of the same-level XOR cell in the intermediate XOR cells.

In some feasible examples, a first logic input end of the intermediate XOR cell is connected to a second logic output end of the same-level XOR cell on a side of the intermediate chain and close to the boundary chain, a second logic input end of the intermediate XOR cell is connected to a data output end of the same-level scan-cell in the intermediate chain and away from the boundary chain, a first logic output end of the intermediate XOR cell is connected to a second data input end of the same-level scan-cell in the intermediate chain and away from the boundary chain, and a second logic output end of the intermediate XOR cell is connected to a first logic input end of the same-level XOR cell on a side of the intermediate chain and away from the boundary chain.

In some feasible examples, a first logic input end of the tail XOR cell is connected to a second logic output end of the same-level XOR cell in the intermediate chain and close to the boundary chain, a second logic input end of the tail XOR cell is connected to a data output end of the same-level scan-cell in the intermediate chain away from the boundary chain, a first logic output end of the tail XOR cell is connected to a second data input end of the same-level scan-cell in the intermediate chain and away from the boundary chain, and a second logic output end of the tail XOR cell is connected to a second data input end of the scan-cell 101 in the dedicated debug chain 20.

Illustratively, since the fault location circuit provided in the example has universality for performing high-precision location diagnosis on faulty scan-cells, the example of the invention explains in detail as follows for two different fault scenarios occurring in the vertical scan chain, and analysis principles of other fault situations are consistent. There are two main types of faults in a scan chain: stuck-at faults and delay faults. The stuck-at faults include a stuck-at-1 (SA1) fault and a stuck-at-0 (SA0) fault. That is, in an internal circuit, mainly due to the problem of preparation technology, output values of some scan-cells in the scan chain are always fixed at 1 or 0 regardless of an excitation value. The delay faults mainly include a fast-to-rise (FTR) fault, a fast-to-fall (FTF) fault, a slow-to-rise (STR) fault, a slow-to-fall (STF) fault, etc. In the example, only the STF fault is taken as an instance for explanation, and other fault types can be derived similarly. After a scan-cell of the STF fault type, the data should have gone from 1 to 0 on a next clock trigger. However, due to the problem that output data of the current faulty scan-cell fall too slowly, the output of the scan-cell remains at 1 when the next clock arrives. This type of fault can lead to advancement or lag of the output data of the scan-cell by one clock cycle. A final output result of the delay type fault can also be attributed to the stuck-at fault, such that the example mainly explains the stuck-at faults SA0 and SA1.

### Scenario 1

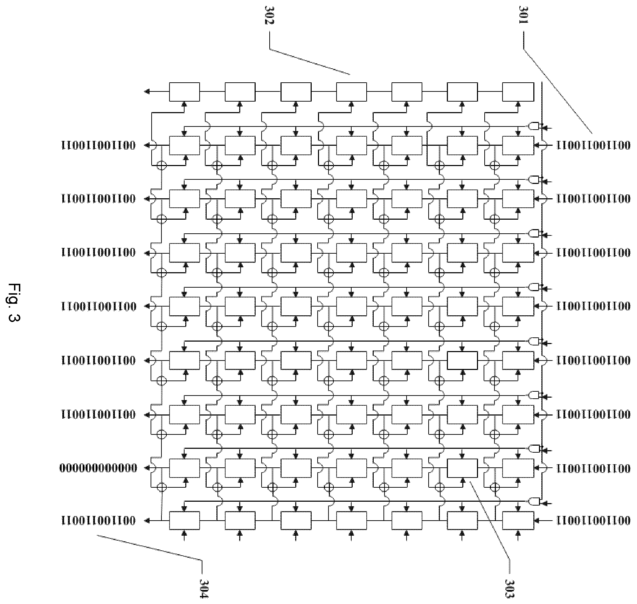

Reference may be made to Fig. 3 for a case of a single fault type. Fig. 3 is a schematic diagram of an application scenario of a fault location circuit according to an example of the invention. As shown in Fig. 3, assuming that an SA0 fault occurs in a second scan-cell of a second vertical scan chain 303 from the right, a location flow of the fault location circuit provided in the example is as follows:
3.1) A 301 test vector 001100110011 is input to first data input ends of all vertical scan chains simultaneously except a dedicated debug chain 302.
3.2) The test vector is shifted and output from data output ends of the scan chains over several clock cycles, and output vector sequences 304 are detected.
3.3) Compared with the input 301 test vector, the output vector of the second vertical scan chain from the right has a sequence of 000000000000, and the sequences of the output vectors of other scan chains are all kept as 001100110011, thus a fault can be located at the second scan chain, that is, a column coordinate of the fault is obtained.
3.4) According to the fact that the output test vectors are all 0, it can be deduced that the fault type of the second scan chain is SA0. In this case, single vectors 1 are shifted and input from the first data input ends to the second faulty scan chain and the scan chain adjacent to the right of the second faulty scan chain, and single vectors 0 are shifted and input to the first data input ends of the remaining vertical scan chains.
3.5) An output vector sequence of the dedicated debug chain 302 is detected. Since an output value of a scan-cell with normal functions in the faulty scan chain is 1, which is the same as an output value of a scan-cell adjacent to the right of the scan-cell with normal functions, and through XOR logic, a result is 0. Output values of other same-level scan-cells are all 0. Through XOR one by one, the value is always kept as 0, and finally transmitted to the same-level scan-cell of the dedicated debug chain. However, when a scan-cell with an SA0 fault is encountered, since its output value is 0, and its output value of 0 is opposite to an output value 1 of a scan-cell adjacent to the right of the scan-cell with an SA0, a result of XOR of the two scan-cells is 1. Output values of the remaining same-level scan-cells remains 0. When XOR processing is performed from right to left, it can be found that the output value always remains 1, and finally transmitted to the corresponding scan-cell of the dedicated debug chain 302. Thus the row coordinate of the faulty scan-cell can be obtained according to a position where the data 1 first appears in the output vector sequence of the dedicated debug chain 302, and then the specific position of the scan-cell of the faulty vertical scan chain can be accurately located.
3.6) Since the example identifies the fault according to the position where the data 1 first appears in the output vector sequence of the dedicated debug chain 302, in order to eliminate the SA0 fault also exists in other scan-cells of the same faulty scan chain, input data input ends of the remaining scan-cells are selected as the second data input ends, even if they receives XOR results with the scan-cell adjacent to the right, the input of the scan-cell with the SA0 fault is set to 1. Since the output is still 0, fault determination can be achieved by observing the XOR results of this level that are finally passed to the corresponding scan-cells of the dedicated debug chain.

### Scenario 2

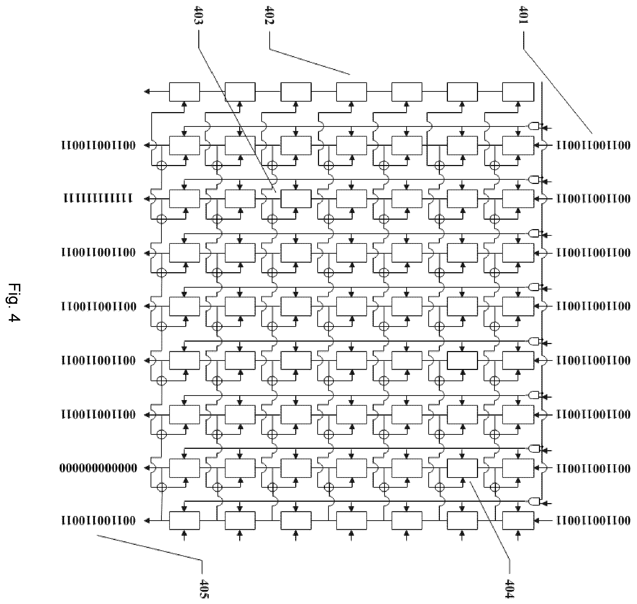

Reference may be made to Fig. 4 for a case of a plurality of fault types. Fig. 4 is a schematic diagram of another application scenario of a fault location circuit according to an example of the invention. As shown in Fig. 4, assuming that an SA0 fault occurs in a second scan-cell of a second vertical scan chain 404 from the right, and an SA1 fault occurs in a fifth scan-cell of a seventh vertical scan chain 403, a location flow of the fault location circuit provided in the example is as follows:
4.1) A 401 test vector 001100110011 is input to first data input ends of all vertical scan chains simultaneously except a dedicated debug chain 402.
4.2) The test vector is shifted and output from data output ends of the scan chains over several clock cycles, and output vector sequences 405 are detected.
4.3) Compared with the input 401 test vector, the output vector of the second vertical scan chain has a sequence of 000000000000, the output vector of the seventh vertical scan chain has a sequence of 111111111111, and the sequences of other output vectors 405 are all kept as 001100110011, thus an SA0 fault can be located at the second scan chain, and an SA1 fault can be located at the seventh scan chain, that is, column coordinates of the faulty scan-cells are obtained.
4.4) The 0 vector is shifted and input to all vertical scan chains simultaneously, and it is known that the output of the scan-cell at the level with the SA1 fault is transmitted to the corresponding scan-cell of the dedicated debug chain 402 through sequential XOR processing, and has a value of 1. Then, in the vector shifted and output from the dedicated debug chain 402, a position where the data 1 first appears is an accurate position of the scan-cell with the SA1 fault, and the positions of the remaining scan-cell with the SA0 fault can then be determined in the same manner as Scenario 1.

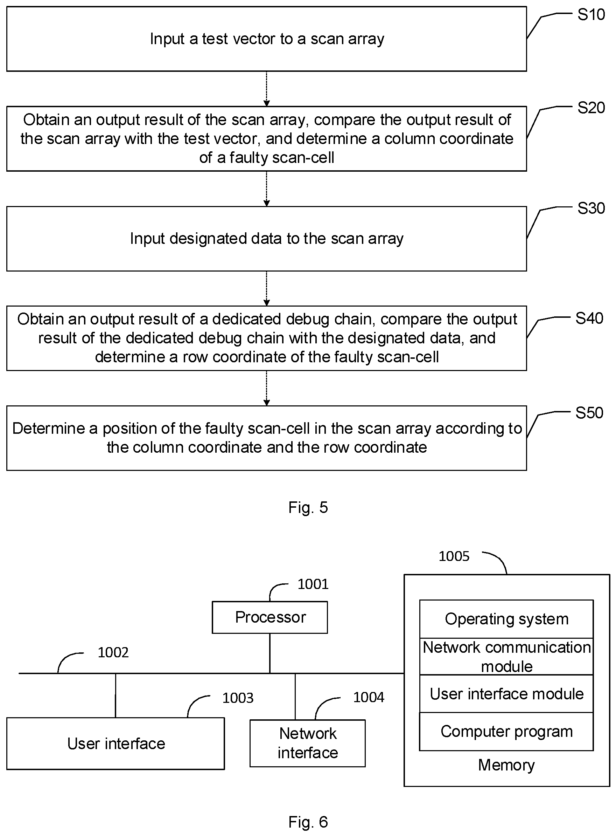

Moreover, the examples of the invention further provide a fault location method. The fault location method can be applied to the fault location circuit. With reference to Fig. 5, Fig. 5 is a schematic flowchart of a fault location method according to an example of the invention. As shown in Fig. 5, the fault location method in the example include S10 to S50.

S10, a test vector is input to a scan array.

S20, an output result of the scan array is obtained, the output result of the scan array is compared with the test vector, and a column coordinate of a faulty scan-cell is determined.

S30, designated data are input to the scan array.

S40, an output result of a dedicated debug chain is obtained, the output result of the dedicated debug chain is compared with the designated data, and a row coordinate of the faulty scan-cell is determined.

S50, a position of the faulty scan-cell in the scan array is determined according to the column coordinate and the row coordinate.

The example can be understood in combination with the examples of the fault location circuit and the accompanying drawings. First, test vectors for being input to scan chains in the vertical direction in the scan array are generated. The same test vectors are shifted to an internal circuit along common scan chains in the vertical direction, and vector values are detected at the output ends of the scan array (that is, output results are obtained) under drive of a shift clock. Then the input and output vector values are compared. In a case that they are the same, and output of the dedicated debug chain is all 0 vectors, it indicates that the scan chain has no defects. In a case that the output vectors have changes, the vertical scan chain with faults can be diagnosed, that is, column coordinates are obtained. For the vertical scan chains with faults, a specific diagnosis vector (that is, designated data) is regenerated. The specific diagnosis vector is repeatedly input to the first data input end of each scan chain, such that the diagnosis vector can be shifted to the inside of the circuit. In this case, every scan-cell is passed through, the output values in the horizontal direction sequentially pass through the XOR logic, finally are transmitted to the corresponding scan-cell of the dedicated debug chain, and then shifted and output along the dedicated debug chain. The row coordinate of the faulty scan-cell can be obtained by determining the position where 1 first appears in the output vector of the dedicated debug chain. Finally, the position of the faulty scan-cell can be determined according to the column coordinate and the row coordinate. Moreover, in order to avoid missing subsequent faulty scan-cells in the same scan chain, the scan-cell in the faulty scan chain may be set through the second data input end, such that the faulty scan-cell can be accurately located. According to different actual fault types, the step of setting may be iterated a plurality of times until the determined position of the faulty scan-cell is obtained.

The fault location circuit provided in the example is applied to the above fault location circuit. A scan chain with a fault can be identified by using a conventional scan chain diagnosis method, that is, the column coordinate of the faulty scan-cell can be obtained. Then a specific test vector is shifted and input. Output of the same-level scan-cells are subjected to XOR operation sequentially, then values are captured by the corresponding scan-cells on the dedicated debug chain, and the row coordinate of the faulty scan-cell is obtained. For complex cases, the scan-cell in the faulty scan chain can also be set for accurately locating the faulty scan-cell. The pollution caused by the faulty scan-cell to the subsequent data during data shifting can be effectively solved. Finally, high-precision location of the faulty scan-cell is implemented. Compared with the two-dimensional serial chain, the dedicated debug chain in the example can multiplex ordinary vertical scan chains without introducing other hardware overhead, such that no congestion problem occurs in subsequent layout and routing. Compared with the diagnosis location method of optimizing a scan chain fault diagnosis algorithm or introducing machine learning, the fault location method implemented based on the fault location circuit including the dedicated debug chain in the example does not need complex logic calculation, and can efficiently and accurately locate the faulty scan-cell without the problem of unbalanced number of faulty scan-cells.

The fault location method provided in the example belongs to the same invention concept as the fault location circuit provided in the above examples. Reference may be made to any one of the above examples for technical details not described in detail in the example, and the example has the same beneficial effect as the fault location circuit.

In addition, the examples of the invention further provide a chip. The chip includes the fault location circuit and may perform the fault location method applied to the fault location circuit. The fault location circuit may be implemented by software and/or hardware and integrated in the chip.

With reference to Fig. 6, Fig. 6 is a schematic structural diagram of hardware of a chip according to an example of the invention. As shown in Fig. 6, the chip may include a processor 1001, such as a central processing unit (CPU), a communication bus 1002, a user interface 1003, a network interface 1004, and a memory 1005. The communication bus 1002 is used to implement connection communication between these components. The user interface 1003 may include a display, and an input unit such as a keyboard. The optional user interface 1003 may alternatively include a standard wired interface and a wireless interface. The network interface 1004 may optionally include a standard wired interface or a wireless interface (for example, a Wireless-Fidelity (WI-FI) interface). The memory 1005 may be a high-speed random access memory (RAM) or a stable non-volatile memory (NVM), such as a disk memory. The memory 1005 may optionally be a storage apparatus independent of the processor 1001.

It should be understood by a person skilled in the art that a structure shown in Fig. 6 is not intended to limit the chip. The chip may include more or fewer components than those in Fig. 6, some of the components may be combined, or different arrangements of the components may be used. As shown in Fig. 6, the memory 1005 as a storage medium may include an operating system, a data storage module, a network communication module, a user interface module, and a computer program.

In the chip shown in Fig. 6, the network interface 1004 is mainly used for data communication with other apparatuses. The user interface 1003 is mainly used for data interaction with a user. The processor 1001 and the memory 1005 in the example may be arranged in the chip. The chip calls the computer program stored in the memory 1005 through the processor 1001, and performs the fault location method applied to the chip and provided in any of the above examples.

The chip provided in the example belongs to the same invention concept as the fault location method applied to the fault location circuit and provided in the above examples. Reference may be made to any one of the above examples for technical details not described in detail in the example, and the example has the same beneficial effect as execution of the fault location method.

Moreover, the examples of the invention further provide a computer-readable storage medium. The computer-readable storage medium may be a non-volatile computer-readable storage medium. The computer-readable storage medium stores a computer program. The computer program implements the fault location method according to any one of the examples when executed by a processor.

Those of ordinary skill in the art can understand that all or some steps and systems in the disclosed method above can be implemented as software, firmware, hardware, and their appropriate combinations. Some or all of the physical components may be implemented as software executed by a processor, such as a central processing unit, a digital signal processor, or a microprocessor, or as hardware, or as an integrated circuit, such as an application specific integrated circuit. Such software may be distributed on a computer readable medium, which may include a computer storage medium (or a non-transitory medium) and a communication medium (or a transitory medium). As is well known to those of ordinary skill in the art, the term of computer storage medium includes volatile and nonvolatile, removable and non-removable media implemented in any method or technology for storing information (such as a computer readable instruction, a data structure, a program module, or other data). The computer storage medium includes, but is not limited to, an RAM, a read-only memory (ROM), an electrically erasable programmable read-only memory (EEPROM), a flash memory or other magnetic disk memories; a compact disk read-only memory (CD-ROM), a digital video disk (DVD) or other optical disk memories, a magnetic cassette, a magnetic tape, a magnetic disk storage or other magnetic memories, or any other media that can be used to store desired information and can be accessed by a computer. Further, as is well known to those of ordinary skill in the art, the communication medium typically contains a computer readable instruction, a data structure, a program module, or other data in a modulated data signal such as a carrier wave or other transmission mechanisms, and may include any information delivery medium.

The preferred examples of the examples of the invention have been specifically described above, but the examples of the invention are not limited to the above embodiments, those skilled in the art may also make various equivalent modifications or substitutions without departing from the spirit of the examples of the invention, and these equivalent modifications or substitutions are included in the scope defined by the claims of the examples of the invention.

## Claims

1. A fault location circuit, comprising: a scan array and a dedicated debug chain, wherein
the scan array comprises a plurality of scan-cells and XOR cells, the scan-cells are sequentially connected end to end in a first direction to form a plurality of columns of scan chains, the scan-cells adjacent in a second direction are same-level scan-cells, the XOR cells are arranged between the same-level scan-cells, the XOR cells adjacent in the second direction are same-level XOR cells, and the same-level XOR cells in the second direction are sequentially connected to form an XOR chain, wherein the first direction is different from the second direction;
the dedicated debug chain consists of the plurality of scan-cells sequentially connected end to end in the first direction, and the scan-cells in the dedicated debug chain are connected to output ends of the XOR chains respectively; and
an output result of the scan array is used to determine a column coordinate of a faulty scan-cell, and an output result of the dedicated debug chain is used to determine a row coordinate of the faulty scan-cell.

2. The fault location circuit according to claim 1, wherein each scan-cell comprises:
a first data input end configured to receive a test vector;
a second data input end configured to receive setting data;
a data selection end configured to selectively receive the test vector or the setting data; and
a data output end configured to output a detection result.

3. The fault location circuit according to claim 2, wherein each XOR cell comprises a first logic input end, a second logic input end, a first logic output end, and a second logic output end.

4. The fault location circuit according to claim 3, wherein the scan chains comprise a boundary chain and intermediate chains;
the XOR cells comprise a head XOR cell arranged between the boundary chain and the intermediate chain, an intermediate XOR cell arranged between two intermediate chains, and a tail XOR cell closest to the dedicated debug chain; and
the head XOR cell, the intermediate XOR cell and the tail XOR cell are sequentially connected to form the XOR chain.

5. The fault location circuit according to claim 4, wherein a first logic input end of the head XOR cell is connected to a data output end of the same-level scan-cell in the boundary chain, a second logic input end of the head XOR cell is connected to a data output end of the same-level scan-cell in the intermediate chain, a first logic output end of the head XOR cell is connected to a second data input end of the same-level scan-cell in the intermediate chain, and a second logic output end of the head XOR cell is connected to a first logic input end of the same-level XOR cell in the intermediate XOR cells.

6. The fault location circuit according to claim 4, wherein a first logic input end of the intermediate XOR cell is connected to a second logic output end of the same-level XOR cell on a side of the intermediate chain and close to the boundary chain, a second logic input end of the intermediate XOR cell is connected to a data output end of the same-level scan-cell in the intermediate chain and away from the boundary chain, a first logic output end of the intermediate XOR cell is connected to a second data input end of the same-level scan-cell in the intermediate chain and away from the boundary chain, and a second logic output end of the intermediate XOR cell is connected to a first logic input end of the same-level XOR cell on a side of the intermediate chain and away from the boundary chain.

7. The fault location circuit according to claim 4, wherein a first logic input end of the tail XOR cell is connected to a second logic output end of the same-level XOR cell in the intermediate chain and close to the boundary chain, a second logic input end of the tail XOR cell is connected to a data output end of the same-level scan-cell in the intermediate chain away from the boundary chain, a first logic output end of the tail XOR cell is connected to a second data input end of the same-level scan-cell in the intermediate chain and away from the boundary chain, and a second logic output end of the tail XOR cell is connected to a second data input end of the scan-cell in the dedicated debug chain.

8. A fault location method, applied to the fault location circuit according to any one of claims 1 to 7, comprising:
inputting a test vector to a scan array;
obtaining an output result of the scan array, comparing the output result of the scan array with the test vector, and determining a column coordinate of a faulty scan-cell;
inputting designated data to the scan array;
obtaining an output result of a dedicated debug chain, comparing the output result of the dedicated debug chain with the designated data, and determining a row coordinate of the faulty scan-cell; and
determining a position of the faulty scan-cell in the scan array according to the column coordinate and the row coordinate.

9. A chip, comprising: a memory, a processor, and a computer program stored on the memory and runnable on the processor, wherein the computer program implements the fault location method according to claim 8 when executed by the processor.

10. A computer-readable storage medium, storing a computer program, wherein the computer program implements the fault location method according to claim 8 when executed by a processor.
